# EUROPÄISCHE PATENTANMELDUNG

(11) **EP 4 826 321 A1**
(43) Veröffentlichungstag der Anmeldung: **21.10.2026**
(21) Anmeldenummer: 26172325.8
(22) Anmeldetag: 14.04.2026
(51) Int. Cl.: F27D 21/00, G01F 23/284, G01S 13/08, G01S 13/88, H01Q 1/22, H01Q 19/06

(54) **SCHMELZKAMMER UND VORRICHTUNG ZUR DURCHFÜHRUNG VON ABSTANDSMESSUNGEN IM INNENRAUM EINER SCHMELZKAMMER**

(30) Priorität: 16.04.2025 DE 102025115039
(71) Anmelder: OndoSense GmbH, 79111 Freiburg im Breisgau (DE)
(72) Erfinder: Hülsmann, Axel, 79104 Freiburg i. Br. (DE); Meisenheimer, Matthias, 79106 Freiburg i. Br. (DE); Massagli, Alexandre, 18017-421 Sorocaba (Sao Paulo) (BR)
(74) Vertreter: Huwer, Andreas

(57) **Zusammenfassung**

Eine Vorrichtung (1) zur Durchführung von Abstandsmessungen an einer in dem Innenraum (2) einer Schmelzkammer (3) befindlichen Schmelze (4) und/oder eines in dem Innenraum (2) befindlichen, zu schmelzenden Schüttguts (5) weist einen Radar (6) auf, das mindestens eine Radarantenne (7) zum Senden und Empfangen von Radarstrahlung und eine damit zusammenwirkende Radarelektronik (9) aufweist, die zur Abstandsmessung nach dem Laufzeitprinzip ausgestaltet ist. Die Vorrichtung (1) hat ein Strahlführungsrohr (18) mit einer für die Radarstrahlung (8) reflektierenden, eine Rohrinnenhöhlung (19) umgrenzenden Innenwand. Das Strahlführungsrohr (18) ist an seinen beiden Axialenden für die Radarstrahlung offen und die Radarantenne (7) ist einem der Axialenden des Strahlführungsrohrs (18) zugewandt. Das Radar (6) ist derart ausgestaltet und ausgerichtet, dass die von ihm ausgesendete Radarstrahlung durch die Rohrinnenhöhlung (19) des Strahlführungsrohrs (18) hindurch zu dem gegenüberliegenden anderen Axialende des Strahlführungsrohrs (18) gelangt und dort aus dem Strahlführungsrohr (18) austritt (Fig. 1).

## Beschreibung

Die Erfindung betrifft eine Vorrichtung zur Durchführung von Abstandsmessungen an einer in dem Innenraum einer Schmelzkammer befindlichen Schmelze und/oder eines in dem Innenraum befindlichen, zu schmelzenden Schüttguts, mit einem Radar, das mindestens eine Radarantenne zum Senden und Empfangen von Radarstrahlung und eine damit zusammenwirkende Radarelektronik aufweist, die zur Abstandsmessung nach dem Laufzeitprinzip ausgestaltet ist. Außerdem betrifft die Erfindung einen Schmelzofen, mit einer solchen Vorrichtung, wobei der Schmelzofen eine durch Außenwände begrenzte Schmelzkammer hat, die einen Innenraum mit einem Aufnahmebereich für eine Schmelze begrenzt, und wobei mindestens eine Außenwand einen Wanddurchbruch aufweist, der höher angeordnet ist als der Aufnahmebereich für die Schmelze.

Eine derartige Vorrichtung und ein derartiger Schmelzofen sind aus der EP 0 633 441 A1 bekannt. Der Schmelzofen hat eine durch einen Boden, Seitenwände und eine Decke begrenzte Schmelzkammer, die einen Innenraum umgrenzt, der in einem bodennahen Teilbereich, welcher sich bis zu einem Niveau erstreckt, an dem die Schmelzkammer einen Überlauf aufweist, einen Aufnahmebereich für die Schmelze hat. Zum Beheizen weist die Schmelzkammer mehrere Heizelemente auf, die oberhalb des Aufnahmebereichs für die Schmelze an der Decke der Schmelzkammer angeordnet sind. An der Decke der Schmelzkammer ist ein Radar zur Messung des Niveaus der Schmelze angeordnet. Zum Senden und Empfangen von Radarstrahlung hat das Radar eine als Hornantenne ausgestaltete Radarantenne und eine damit zusammenwirkende Radarelektronik. An der Stelle, an der sich das Radar befindet, hat die Decke der Schmelzkammer einen Deckendurchbruch, in dem die Radarantenne angeordnet ist. Unterhalb der auf den Aufnahmebereich für die Schmelze ausgerichteten Radarantenne ist in dem Deckendurchbruch ein radartransparentes Fenster angeordnet, welches an seinem Außenrand dicht mit der Decke der Kammer verbunden ist. Hierdurch soll vermieden werden, dass heiße Gase aus der Schmelzkammer durch den Deckendurchbruch hindurch zu dem Radar gelangen.

Oberhalb der Radarantenne weist das Radar ein Elektronikgehäuse auf, in dem die Radarelektronik angeordnet ist. Ein unterer Abschnitt des Elektronikgehäuses greift in den Deckendurchbruch ein und das restliche Elektronikgehäuse steht aus dem Deckendurchbruch bis über die der Innenhöhlung der Schmelzkammer abgewandte Oberfläche der Decke vor.

Damit die Radar-Elektronik vor unzulässig hohen Temperaturen und widrigsten Umwelteinflüssen geschützt wird, ist das Elektronikgehäuse in einem Radargehäuse angeordnet, das als Gehäusewand ein Rohrstück aufweist, welches mit seiner Längsachse orthogonal zu der von der Decke der Schmelzkammer aufgespannten Ebene ausgerichtet ist und mit einem unteren Abschnitt in den Deckendurchbruch eingreift. Das Rohrstück ist an seinem oberen Ende mit einem Deckel verschlossen und weist an seiner Innenwand einen von dem Deckel beabstandeten Innenflansch auf, auf dem das Elektronikgehäuse mit seinem Boden aufliegt. Zwischen dem Elektronikgehäuse und dem Rohrstück sowie zwischen dem Elektronikgehäuse und dem Deckel ist ein Zwischenraum gebildet, in dem eine Einlassöffnung zum Zuführen von Kühlgas und ein Auslass für das Kühlgas angeordnet sind. An seinem unteren, dem radartransparentes Fenster zugewandten Ende hat das Rohrstück eine Öffnung, welche die Radarstrahlung durchdringt.

Die Querschnittsabmessungen des Deckendurchbruchs sind größer als die entsprechenden Querschnittsabmessungen des Radargehäuses und größer als die entsprechenden Querschnittsabmessungen des Elektronikgehäuses. Dies führt zu großen Öffnungen in der Wärmeisolierung der Schmelzkammer.

Aufgabe der Erfindung ist es, eine Vorrichtung der eingangs genannten Art zu schaffen, die - wenn Sie an einem Wanddurchbruch einer Schmelzkammer der eingangs genannten Art montiert ist - beim Betrieb der Schmelzkammer geringe Wärmeverluste an dem Wanddurchbruch ermöglicht. Außerdem besteht die Aufgabe, eine Schmelzkammer mit einer solchen Vorrichtung anzugeben.

Diese Aufgabe wird bezüglich der Vorrichtung der eingangs genannten Art dadurch gelöst, dass die Vorrichtung ein Strahlführungsrohr mit einer für die Radarstrahlung reflektierenden, eine Rohrinnenhöhlung umgrenzenden Innenwand hat, dass das Strahlführungsrohr an seinen beiden Axialenden für die Radarstrahlung offen und die Radarantenne einem der Axialenden des Strahlführungsrohrs zugewandt ist, und dass das Radar derart ausgestaltet und ausgerichtet ist, dass die von ihm ausgesendete Radarstrahlung durch die Rohrinnenhöhlung des Strahlführungsrohrs hindurch zu dem gegenüberliegenden anderen Axialende des Strahlführungsrohrs gelangt und dort aus dem Strahlführungsrohr austritt.

Da die von der Radarantenne ausgesendete Radarstrahlung beim Durchtritt durch das Strahlführungsrohr an der Innenwand des Strahlführungsrohrs reflektiert werden kann, reicht bereits ein relativ geringer Rohrquerschnitt aus, um die Radarstrahlung verlustarm von dem der Radarantenne zugewandten Ende des Strahlführungsrohrs zu dem gegenüberliegenden anderen Axialende des Strahlführungsrohrs zu leiten. Die erfindungsgemäße Vorrichtung kann derart an einem Schmelzofen, der eine Außenwand mit einem Wanddurchbruch hat, angeordnet werden, dass sich das Radar außerhalb der Schmelzkammer des Schmelzofens befindet und das Strahlführungsrohr zumindest einen an die Schmelzkammer angrenzenden Abschnitt des Wanddurchbruchs durchsetzt, um die von der Radarantenne ausgesendete Radarstrahlung durch das Strahlführungsrohr hindurch in die Schmelzkammer zu leiten. Radarstrahlung, die an der in der Schmelzkammer befindlichen Schmelze und/oder darin befindlichem zu schmelzenden Material reflektiert wird, wird durch das Strahlführungsrohr hindurch zu der Radarantenne geleitet und dort empfangen.

In vorteilhafter Weise ermöglicht es die erfindungsgemäße Vorrichtung, die Radarstrahlung weitgehend verlustarm durch einen Wanddurchbruch mit geringem Querschnitt hindurchzuleiten, ohne dass die Radarstrahlung an dem an den Wanddurchbruch angrenzenden Rand der Wand absorbiert wird. Wenn die Wand eine Wärmeisolierung aufweist, wie das bei einer Außenwand eines Schmelzofens üblicherweise der Fall ist, wird eine Absorption der Radarstrahlung an der Wärmeisolierung, die z.B. Mineralwolle enthalten kann, vermieden. Aufgrund des geringen Querschnitts des Wanddurchbruchs treten beim Betrieb des Schmelzofens an dem Wanddurchbruch nur geringe Wärmeverluste auf. Dadurch reduziert sich auch die thermische Belastung der Radarelektronik.

Die Reflexion der Radarstrahlung an der Innenwand des Strahlführungsrohrs kann zwar dazu führen, dass Radarstrahlen, die von der Radarantenne unter unterschiedlichen Winkeln abgestrahlt und in das Strahlführungsrohr eingekoppelt werden, auf unterschiedlich langen Wegen zu dem von dem Radar entfernten Axialende des Strahlführungsrohrs gelangen. Hierdurch können bei der Abstandsmessung nach dem Laufzeitprinzip Messungenauigkeiten auftreten. Bei bestimmten Anwendungen, wie z.B. dem Messen des Niveaus einer Schmelze in einem Schmelzofen, kann das jedoch toleriert werden.

Das Strahlführungsrohr besteht vorzugsweise aus Metall. Es kann aber auch aus einem anderen Material bestehen, das für die an einem Schmelzofen auftretende Wärmebelastung geeignet ist und die Radarstrahlung reflektiert, insbesondere wenn sie unter einem flachen Winkel auf die Innenwand des Strahlführungsrohrs auftrifft. Ein solches Material ist beispielsweise Keramik. Das Strahlführungsrohr kann im Querschnitt eckig oder rund sein.

Das Radar arbeitet vorzugsweise nach dem bekannten FMCW-Prinzip, das nach dem Mischen des Sendesignals mit dem Empfangssignal ein niederfrequentes Frequenz-Spektrum erzeugt, dessen Maxima den Reflexionsabständen zugeordnet werden können. Die Frequenzen der Maxima sind proportional zu den Entfernungen der Reflexionen. Die Störreflexionen werden weitestgehend eliminiert, da für die Abstandsmessung zum Schmelzgut nur der höherfrequente Teil des Spektrums zur Auswertung kommt, der durch Reflexion der Radarstrahlung an der Schmelze bzw. dem zu schmelzenden Schüttgut verursacht wird, die weiter von der Radarantenne entfernt sind als das der Radarantenne abgewandte Axialende des Strahlführungsrohrs.

Vorteilhaft ist, wenn die Querschnittsabmessungen der Rohrinnenhöhlung des Strahlführungsrohrs kleiner sind als die entsprechenden Außenquerschnittsabmessungen des Radars. Wenn das Radar außerhalb des Innenraums der Schmelzkammer und außerhalb des Wanddurchbruchs der Außenwand der Schmelzkammer angeordnet ist, braucht der Querschnitt des Wanddurchbruchs der Außenwand somit nur für den relativ kleinen Querschnitt des Strahlführungsrohrs dimensioniert zu werden. Hierdurch werden die Wärmeverluste an dem Wanddurchbruch weiter reduziert.

Bei einer Weiterbildung der Erfindung ist vorgesehen, dass das Radar zum Reduzieren des Öffnungswinkels der von der Radarantenne ausgesendeten Radarkeule eine dielektrische, vorzugsweise elliptische Linse aufweist, und dass die dielektrische Linse zwischen der Radarantenne und dem Strahlführungsrohr angeordnet ist. Dies ermöglicht das Einkoppeln einer Radarkeule mit sehr kleinem Öffnungswinkel in das Strahlführungsrohr, was eine kleine Querschnittabmessung des Strahlführungsrohrs ermöglicht. Die dielektrische Linse ist bevorzugt als massiver Linsenkörper ausgestaltet, der eine Einkoppelfläche für die Radarstrahlung und eine Mantelfläche aufweist. Die Mantelfläche liegt in der Oberfläche eines gedachten Rotationsellipsoids. Die Einkoppelfläche ist zwischen den beiden Brennpunkten des Rotationsellipsoids und mit Abstand zu diesen angeordnet, so dass ein Brennpunkt (F1) des Rotationsellipsoids außerhalb des Linsenkörpers und der andere Brennpunkt (F2) innerhalb des Linsenkörpers angeordnet ist. Vorzugweise liegt die Einkoppelfläche in einer orthogonal zur der durch die beiden Brennpunkte (F1 und F2) verlaufenden Gerade. Die Radarantenne oder deren virtuelle Abstrahlstelle ist in dem außerhalb des Linsenkörpers liegenden Brennpunkt (F1) angeordnet. Der Durchmesser der elliptischen Linse bzw. des Rotationsellipsoids kann mindestens das Sechsfache, gegebenenfalls mindestens das Achtfache und bevorzugt mindestens das Zehnfache der Wellenlänge λ der Radarstrahlung betragen. Die dielektrische Linse kann derart ausgestaltet sein, dass der auf die virtuelle Abstrahlstelle der Radarantenne bezogene -3 dB Öffnungswinkel α der Radarkeule kleiner als oder gleich 6° ist, insbesondere kleiner als oder gleich 5° und bevorzugt kleiner als oder gleich 4° ist.

Vorteilhaft ist, wenn die dielektrische Linse derart ausgestaltet, dass der auf die virtuelle Abstrahlstelle der Radarantenne bezogene -3dB Öffnungswinkel α der Radarkeule die Ungleichung $α \leq 2 arc tan \frac{d}{2 a}$ erfüllt, wobei *d* die lichte Querschnittsabmessung der Rohrinnenhöhlung des Strahlführungsrohrs und *a* der Abstand ist, den die virtuelle Abstrahlstelle der Radarantenne entlang der Längsmittelachse des Strahlführungsrohrs zu der Rohrinnenhöhlung des Strahlführungsrohrs aufweist. Dabei stimmt die Längsmittelachse der Radarkeule vorzugsweise mit der Längsmittelachse des Strahlführungsrohrs überein. Dies ermöglicht eine verlustarme Einkopplung der von der Radarantenne ausgesendeten Radarstrahlung in das Strahlführungsrohr.

Zur thermischen Abschirmung des Radars gegen an dem von dem Radar entfernten Ende des Strahlführungsrohrs herrschende Temperaturen ist bei einer bevorzugten Ausführungsform der Erfindung ein radartransparentes, dielektrisches Fenster in der Rohrinnenhöhlung des Strahlführungsrohrs angeordnet. Dieses erstreckt sich vorzugsweise über den gesamten Querschnitt der Rohrinnenhöhlung des Strahlführungsrohrs. Bei einer Verwendung der Vorrichtung zum Messen des Niveaus einer Schmelze und/oder eines zu schmelzenden Materials in einem Schmelzofen, hält das dielektrische Fenster außer der Wärmestrahlung des Schmelzofens auch die im Schmelzofen auftretenden Gase und Aerosole von dem Radar fern.

Eine zweckmäßige Ausgestaltung der Erfindung sieht vor, dass das Strahlführungsrohr zumindest einen ersten Rohrabschnitt und einen in gerader Verlängerung dazu angeordneten zweiten Rohrabschnitt aufweist, und dass das radartransparente Fenster zwischen diesen Rohrabschnitten angeordnet ist und diese miteinander verbindet. Das radartransparente Fenster ist dabei von dem von dem Radar entfernten Axialende des Strahlführungsrohrs beabstandet, um beim Auftreten von hohen Temperaturen an diesem Axialende die thermische Belastung des radartransparenten Fensters zu reduzieren. Vorzugsweise ist das radartransparente Fenster zu diesem Zweck an oder dicht benachbart zu dem gegenüberliegenden andern Axialende des Strahlführungsrohrs in der Rohrinnenhöhlung des Strahlführungsrohrs positioniert und vorzugsweise gasdicht mit der Innenwand des Strahlführungsrohrs verbunden.

Vorteilhaft ist, wenn die Normale auf die Oberfläche des radartransparenten Fensters unter einem Neigungswinkel β gegenüber der Längsmittelachse des Strahlführungsrohrs verkippt ist, der größer ist als die Hälfte des -3dB Öffnungswinkels α der aus der Linse austretenden Radarkeule. Hierdurch werden direkte Reflexion der von der Radarantenne ausgesendeten Radarstrahlung am radartransparenten Fenster, welche von der Radarantenne empfangen werden, reduziert. Dies verbessert die Messdynamik des Radars. Die Abstände der an dem radartransparenten Fenster auftretenden Störreflektoren sind unveränderlich und kleiner als der Abstand zum Messobjekt. Auch die Signal-Amplituden dieser Störreflexionen sind kleiner als das Nutzsignal. Dadurch lassen sie sich in einer geeigneten elektronischen Signalverarbeitung gezielt wegfiltern. Der Neigungswinkel β beträgt vorzugsweise mindestens 4°.

Vorzugsweise ist das Radar zum Aussenden einer Radarstrahlung mit einer Wellenlänge λ ausgestaltet, wobei die lichte Querschnittsabmessung der Rohrinnenhöhlung des Strahlführungsrohrs zwischen dem Zweifachen und dem Fünfzigfachen der Wellenlänge λ, gegebenenfalls zwischen dem Zweifachen und dem Dreißigfachen der Wellenlänge λ, optional zwischen dem Zweifachen und dem Zwanzigfachen der Wellenlänge λ und bevorzugt zwischen dem Zehnfachen und dem Fünfzigfachen der Wellenlänge λ beträgt. Unter der Wellenlänge λ wird die Freistrahlwellenlänge der Radarstrahlung verstanden.

Bei einer Weiterbildung der Erfindung ist vorgesehen, dass die Radarelektronik ein Differenzierglied zum Erfassen einer Änderung eines Abstandsmesssignals aufweist, und dass das Differenzierglied zum Vergleichen der Änderung des Abstandsmesssignals mit einem Referenzwert oder einem Referenzwertbereich mit einer Vergleichseinrichtung verbunden ist. Dies kann bei einem Schmelzofen, bei dem die erfindungsgemäße Vorrichtung zum Messen des Niveaus einer in einer Schmelzkammer befindlichen Schmelze und/oder eines in der Schmelzkammer befindlichen zu schmelzenden Schüttguts, wie z.B. Schrott oder Granulat, verwendet wird, dazu genutzt werden, um den Zeitpunkt zu bestimmen, an dem sämtliches Schüttgut, das in die Schmelzkammer eingefüllt wurde, geschmolzen ist. Dabei wird davon ausgegangen, dass wenn sich das Abstandsmesssignal nicht mehr ändert oder die Änderung kleiner ist als der Referenzwert, im Wesentlichen sämtliches zu schmelzendes Schüttgut geschmolzen und somit der Schmelzprozess beendet ist.

Bei Schmelzöfen, bei denen an dem Zeitpunkt, an dem sich das Abstandsmesssignal nicht mehr ändert, unterhalb der Oberfläche der Schmelze noch ungeschmolzenes Schüttgut in der Schmelze enthalten sein kann, kann bei Bedarf noch eine vorbestimmte Zeitdauer abgewartet werden, nachdem detektiert wurde, dass sich das Abstandsmesssignal nicht mehr ändert. Diese Zeitdauer wird so bemessen, dass sichergestellt ist, dass nach Ablauf der Zeitdauer der Schmelzprozess beendet ist, sich also kein ungeschmolzenes Schüttgut mehr im Innenraum des Schmelzofens befindet, auch nicht innerhalb der Schmelze.

Bisher konnte der Zeitpunkt des vollständigen Aufschmelzens des Schmelzguts im Schmelzofen nur unzureichend bestimmt werden. Stand der Technik ist ein optisches Fenster oder eine Öffnung im Schmelzofen, durch die ein Arbeiter den Zustand der Schmelze in unregelmäßigen Zeitabständen manuell beobachtet und dann subjektiv entscheidet, ob der Schmelzprozess beendet ist. Nachteilig bei dieser Vorgehensweise ist auch, dass das vollständige Aufschmelzen häufig nur schwer zu erfassen ist, so dass der Ofenprozess sicherheitshalber länger aufrechterhalten wird als nötig. Dadurch wird unnötig viel Energie verbraucht.

Mit Hilfe der vorstehend genannten Weiterbildung der Erfindung kann das Ende des Schmelzprozesses nun sehr genau erfasst werden. Dadurch kann der Schmelzprozess durch Optimierung von Temperatur und Zeit energieeffizient gefahren werden. Dadurch ist eine erhebliche Energieeinsparung möglich und durch die Zeiteinsparung kann die Auslastung des Ofens erhöht werden, wodurch Kosten in erheblichem Umfang gespart werden. Bei Bedarf kann zusätzlich das Volumen der Schmelze durch die Abstandsmessung am Ende des Schmelzprozesse sehr genau bestimmt, wenn die Geometrie der Schmelzkammer des Schmelzofens bekannt ist.

Typischerweise startet der Schmelzprozess, wenn das Schmelzgut beginnt aufzuschmelzen. Das Schmelzgut ist dann zunächst im Ofen inhomogen verteilt. Je nach Ofenkonstruktion gibt es am Schüttkegel des aufzuschmelzenden Schmelzguts oder an Erhöhungen am Rand oder einer anderen Stelle des Innenraums der Schmelzkammer eine inhomogene Verteilung. Während des Aufschmelzens beginnt das Schmelzgut in der Schmelze zu versinken, wodurch sich der Abstand zur Ofendecke verändert. Wenn das Schüttgut vollständig geschmolzen ist, ändert sich der Abstand nicht mehr und die Oberfläche der Schmelze bestimmt den Abstand zur Ofendecke. Die Messvorrichtung, die diesen Abstand misst, muss mit den Gegebenheiten der hohen Temperatur, der Eigenstrahlung der Schmelze und der Schmelzobjekte, Dämpfen und Rauch, sowie dem Plasma oder Brennerflammen im Ofen zurechtkommen.

Bei einer bevorzugten Ausgestaltung der Erfindung hat die Vorrichtung ein mit dem der Radarantenne zugewandten Axialende des Strahlführungsrohrs verbundenes Radargehäuse, das einen Aufnahmeraum umgrenzt, in dem das Radar angeordnet ist, wobei das Radargehäuse an dem der Radarantenne zugewandten Axialende des Strahlführungsrohrs eine Durchtrittsöffnung für die Radarstrahlung aufweist, und wobei das Radargehäuse mindestens eine Einlassöffnung zum Zuführen von Kühlgas in den Aufnahmeraum und wenigstens einen Auslass für das Kühlgas aufweist. Dies ermöglicht eine effektive Kühlung des Radars, was die Vorrichtung insbesondere für eine Verwendung in oder an einem Schmelzofen geeignet macht.

Bei einer vorteilhaften Ausführungsform der Erfindung ist vorgesehen, dass das Strahlführungsrohr in einem zwischen dem radartransparenten Fenster und dem von der Radarantenne entfernten Axialende des Strahlführungsrohrs befindlichen Abschnitt der Rohrinnenhöhlung einen Einlass zum Zuführen von Kühlgas aufweist. Auch durch diese Maßnahme kann die Temperatur des Radars bei einer Verwendung der Vorrichtung in oder an einem Schmelzofen reduziert werden. Das Kühlgas kann Luft, Stickstoff oder vorzugweise ein Inertgas, wie beispielsweise Argon oder Helium sein. Das dem Einlass zugeführte Kühlgas durchströmt den zwischen dem radartransparenten Fenster und dem von der Radarantenne entfernten Axialende des Strahlführungsrohrs befindlichen Abschnitt der Rohrinnenhöhlung und tritt danach an dem von vom Radar entfernten Axialende des Strahlführungsrohrs in den Innenraum der Schmelzkammer des Schmelzofens aus.

Bezüglich des Schmelzofens der eingangs genannten Art wird die vorstehend genannte Aufgabe dadurch gelöst, dass der Schmelzofen die erfindungsgemäße Vorrichtung aufweist, wobei das Strahlführungsrohr der Vorrichtung den Wanddurchbruch in der Außenwand des Schmelzofens durchsetzt und an seinem Außenumfang dicht mit der Außenwand verbunden ist, und wobei das Radar an dem von dem Innenraum der Schmelzkammer entfernten Axialende des Strahlführungsrohrs vorzugsweise außerhalb des Wandungsdurchbruchs angeordnet ist.

Durch Abstandsmessung nach dem Laufzeitprinzip kann dann mit Hilfe des Radars das Niveau der im Innenraum des Schmelzofens befindlichen Schmelze oder des im Innenraum befindlichen zu schmelzenden Materials gemessen werden. Durch Differenzieren des Abstandssignals und Vergleichen des so erhaltenen differenzierten Signals mit einem Grenzwert oder einem Grenzwertbereich kann außerdem der Zeitpunkt ermittelt werden, an dem ein in der Schmelzkammer ablaufender Schmelzprozess beendet ist.

Bei einer bevorzugten Ausgestaltung des Schmelzofens hat das Strahlführungsrohr an der dem Innenraum zugewandten Innenfläche der den Wanddurchbruch aufweisenden Außenwand einen in den Innenraum vorstehenden Rohrabschnitt, wobei dieser Rohrabschnitt - ausgehend von dem Wanddurchbruch zu dem davon entfernten Ende des Rohrabschnitts - vorzugsweise eine nach unten weisende Komponente hat. Nach dem Austreten des Radarstrahls aus dem Strahlführungsrohr divergiert der Radarstrahl. Dadurch nimmt die Radarstrahlintensität mit 1/R² ab. Hier ist R der kürzeste Abstand zwischen dem freien Ende des in den Innenraum vorstehenden Rohrabschnitts und der Schmelze bzw. dem zu schmelzenden Schüttgut. Der Radarstrahl wird an der Schmelze bzw. dem zu schmelzenden Schüttgut reflektiert. Die Intensität des Radarstrahls, der wieder in das Strahlführungsrohr eingekoppelt wird, nimmt daher noch einmal mit 1/R² ab. Für das Verhältnis zwischen austretender Millimeterwelle-Leistung P_{T} zur Empfangsleistung P_{R} gilt daher $\frac{{P}_{R}}{{P}_{T}} < {R}^{- 4}$

Zur zuverlässigen Radarabstandsmessung muss daher das Ende des Strahlführungsrohrs so nah wie möglich an der Schmelze bzw. dem zu schmelzenden Schüttgut angeordnet sein, um R in obiger Ungleichung möglichst klein zu halten. Andererseits muss R so groß sein, dass das Strahlführungsrohr von der heißen Schmelzofentemperatur nicht geschmolzen wird. Beides kann dadurch erreicht werden, dass sowohl die Länge des in den Innenraum vorstehenden Rohrabschnitts, als auch der Kühlgasstrom entsprechend dimensioniert werden.

Der von dem Strahlführungsrohr durchsetzte Wanddurchbruch ist vorzugsweise in der Decke der Schmelzkammer angeordnet. Er kann aber auch in einer Seitenwand der Schmelzkammer angeordnet sein. Gegebenenfalls ist es sogar möglich, dass in dem Strahlführungsrohr mindestens ein Ablenkspiegel für die Radarstrahlung angeordnet ist, mittels dem die von der Radarantenne ausgesendete Radarstrahlung in Abstrahlrichtung hinter dem Ablenkspiegel mit ihrer Längsmittelachse schräg zur Längsmittelachse des Strahlführungsrohrs aus diesem ausgekoppelt werden kann.

Weitere Einzelheiten, Merkmale und Vorteile der vorliegenden Erfindung ergeben sich aus der nachfolgenden Beschreibung eines Ausführungsbeispiels unter Bezugnahme auf die Zeichnung.

Es zeigt:
- Fig. 1: einen Längsschnitt durch eine Vorrichtung zur Durchführung von Radar-Messungen an einer in dem Innenraum einer Schmelzkammer befindlichen Schmelze, wobei die Mittelachse eines Strahlführungsrohrs der Vorrichtung in der Schnittebene der Zeichnung liegt,
- Fig. 2: einen Teillängsschnitt durch die Vorrichtung, der ein in einem Radargehäuse angeordnetes Radar zeigt, dessen Radarstrahlung in das Strahlführungsrohr eingekoppelt wird, wobei die keulenförmig aus dem Radar austretende Radarstrahlung strichliniert angedeutet ist,
- Fig. 3: einen Längsschnitt durch einen Schmelzofen, der die in Fig. 1 und 2 gezeigte Vorrichtung aufweist, wobei der Schmelzofen stark vereinfacht dargestellt ist, und
- Fig. 4: einen Teillängsschnitt durch das von dem Radar entfernte Axialende des Strahlführungsrohrs, wobei Wellenfronten der Radarstrahlung strichliniert dargestellt sind.

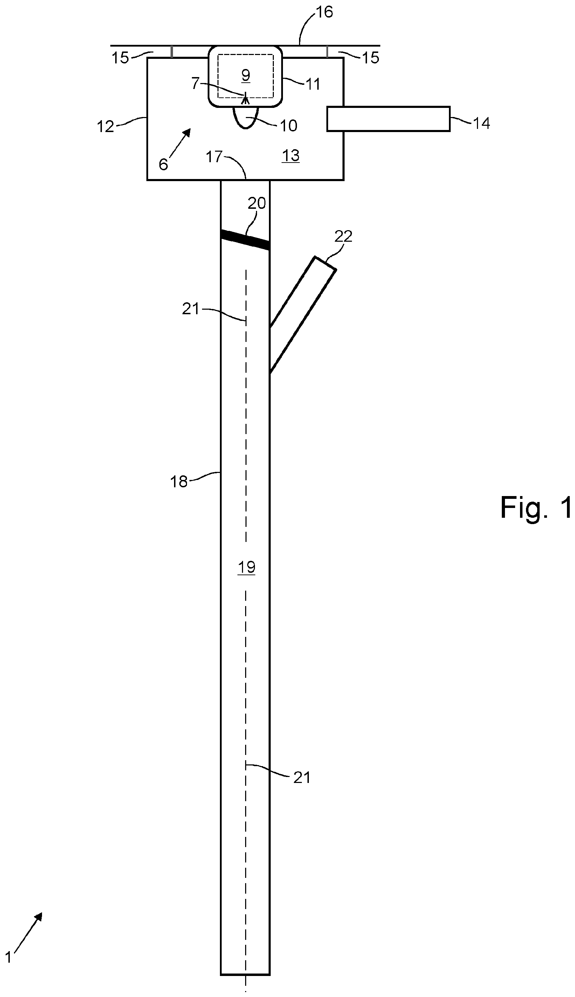

Eine in Fig. 1 im Ganzen mit 1 bezeichnete Vorrichtung zur Durchführung von Abstandsmessungen an einer in dem Innenraum 2 einer Schmelzkammer 3 befindlichen Schmelze 4 und/oder eines in dem Innenraum befindlichen, zu schmelzenden Schüttguts 5 hat ein Radar 6, das eine in Fig. 1 nur schematisch dargestellt Radarantenne 7 zum Senden und Empfangen von Radarstrahlung 8 und eine damit zusammenwirkende Radarelektronik 9 aufweist, die in an sich bekannter Weise zur Abstandsmessung nach dem Laufzeitprinzip ausgestaltet ist. Die Radarwellenlänge der von der Radarantenne 7 ausgesendeten Radarstrahlung beträgt etwa 2,5 mm. Bei der Radarantenne 7 handelt es sich um eine kombinierte Radarantenne, die zum Senden und Empfangen von Radarstrahlung dient. Zum Trennen der Sende- und Empfangssignale weist das Radar 6 einen in der Zeichnung nicht näher dargestellten Richtkoppler auf. Es sind aber auch andere Ausgestaltungen möglich, bei der das Radar zwei dicht zueinander benachbarte Radarantennen aufweist, von denen eine als Sendeantenne und die andere als Empfangsantenne dient.

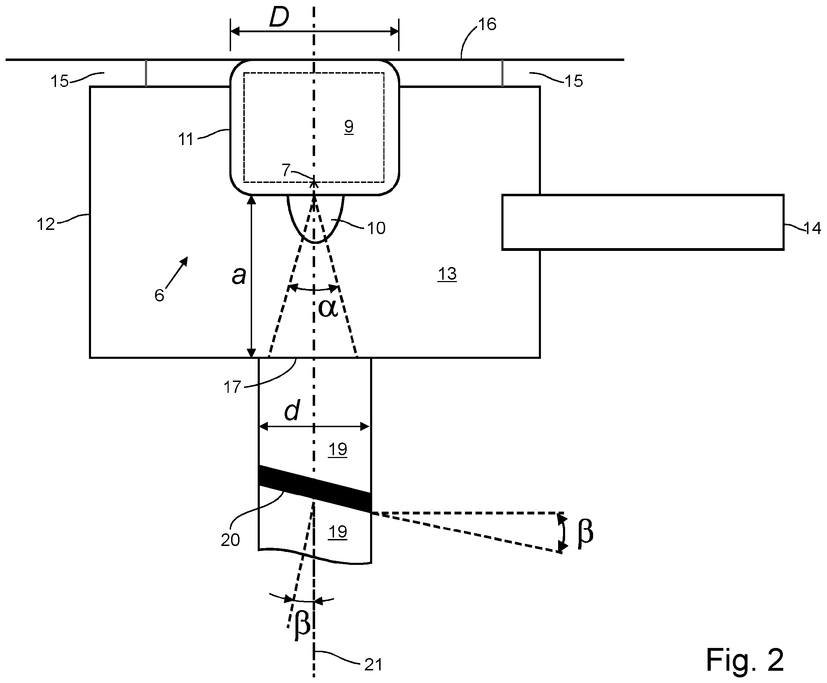

Zum Reduzieren des Öffnungswinkels α der von der Radarantenne 7 ausgesendeten Radarkeule weist das Radar 6 eine dielektrische elliptische Linse 10 aus Teflon auf, welche den -3 dB Öffnungswinkel α der Radarkeule auf unter 4° reduziert. In Fig. 2 ist der Öffnungswinkel α aus Gründen der besseren Lesbarkeit der Zeichnung größer dargestellt. Der Öffnungswinkel bezieht sich auf die virtuelle Abstrahlstelle der Radarantenne.

Der Abstand *a* zwischen der virtuellen Abstrahlstelle des Radars 6 und dem Strahlführungsrohr 18 ist so gewählt, dass die Radarstrahlung 8 in die Rohrinnenhöhlung 19 mit einem Innendurchmesser *d* einkoppelt. Dazu muss die Ungleichung $tan \frac{α}{2} \leq \frac{d}{2 a}$ erfüllt sein.

Wie in Fig. 2 schematisch dargestellt ist, ist die Radarelektronik 9 in einem Elektronikgehäuse 11 angeordnet. Das Radar 6 einschließlich des Elektronikgehäuses 11 und der Linse 10 befindet sich in einem luftgekühlten Radargehäuse 12, das einen Aufnahmeraum 13 für das Radar 6 umgrenzt. Das Radargehäuse 12 hat eine Einlassöffnung 14 zum Zuführen von Kühlgas in den Aufnahmeraum 13.

Das Radargehäuse 12 hat eine Gehäuseunterteil, das das an seiner Oberseite mit einem Deckel 16 verbunden ist, an dem das Radar 6 montiert ist. Zwischen dem Deckel 16 und dem Gehäuseunterteil des Radargehäuses 12 ist ein mit dem Aufnahmeraum 13 verbundener spaltförmiger Auslass 15 vorgesehen, an dem die Kühlluft aus dem Aufnahmeraum 13 austreten kann. An seiner dem Deckel 16 gegenüberliegenden Unterseite hat das Radargehäuse 12 eine Öffnung 17 für den Durchtritt der Radarstrahlung. Durch diese Öffnung hindurch kann die von der Linse 10 abgestrahlte Radarkeule aus dem Radargehäuse 12 austreten. Das Radargehäuse 12 ist rund und hat einen Durchmesser von 125 mm, eine Wandstärke von 2 mm und eine Höhe von 135 mm. Das Radargehäuse 12 muss nicht zwangsläufig rund sein und kann auch eine andere Formgebung aufweisen.

Wie in Fig. 1 und 2 zu sehen ist, hat die Vorrichtung ein Strahlführungsrohr 18 mit einer eine Rohrinnenhöhlung 19 umgrenzenden Innenwand. Das Strahlführungsrohr 18 ist kreiszylindrisch mit einem Innendurchmesser von 50 mm ausgestaltet und besteht aus Edelstahl. Es sind aber auch andere Ausgestaltungen möglich, bei denen das Strahlführungsrohr 18 beispielsweise einen eckigen Querschnitt haben und/oder aus einem anderen hitzebeständigen Material bestehen kann.

Das Strahlführungsrohr 18 ist an seinen beiden Axialenden für die Radarstrahlung offen und mit seiner Längsmittelachse 21 in gerader Verlängerung der Hauptabstrahlrichtung der aus der Linse 10 austretenden Radarkeule angeordnet. An einem Axialende ist das Strahlführungsrohr 18 mit dem die Öffnung 17 umgrenzenden Randbereich des Radargehäuses 12 verbunden. Die Radarantenne 7 und die Linse 10 sind derart ausgerichtet, dass die von der Radarantenne 7 ausgesendete Radarstrahlung 8 an diesem Axialende in die Rohrinnenhöhlung 19 eingekoppelt wird und dann durch die Rohrinnenhöhlung 19 hindurch zu dem gegenüberliegenden anderen Axialende des Strahlführungsrohrs 18 gelangt, um dort aus dem Strahlführungsrohr 18 auszutreten.

Der Durchmesser der Linse 10 beträgt 32 mm. Der Abstand zwischen der virtuellen Abstrahlstelle des Radars und dem Strahlführungsrohr 18 beträgt mit 60 mm und ist somit größer als der Durchmesser der Linse 10. Durch den kleinen -3 dB Öffnungswinkel der von der Linse 10 abgestrahlten Radarkeule von weniger als 4°, dem Abstand von der Linse 10 zum Strahlführungsrohr 18 von 60 mm und dem Innendurchmesser des Strahlführungsrohrs 18 von 50 mm ist sichergestellt, dass die überwiegenden Anteile der vom Radar 6 emittierten Radarwellen in die Rohrinnenhöhlung 19 einkoppeln. Die an die Rohrinnenhöhlung 19 angrenzende Innenwand ist für die Radarstrahlung 8 reflektierend ausgestaltet. Dadurch kann die Radarstrahlung 8 verlustarm durch das Strahlführungsrohr 18 hindurchgeleitet werden.

Wenn die Radarstrahlung 8 nach dem Austritt Strahlführungsrohr 18 auf ein Objekt trifft, an dem sie reflektiert wird, trifft die reflektierte Welle wieder auf die Austrittsstelle am Strahlführungsrohr 18, durchläuft das Strahlführungsrohr 18 und wird dann von dem Radar 6 empfangen.

Aufgrund des Durchmessers d der Rohrinnenhöhlung 19, der 20-mal größer ist als die Radarwellenlänge von 2,5 mm, verhält sich das Strahlführungsrohr 18 wie ein multimodiger Hohlleiter. Durch den multimodigen Hohlleiter entsteht Modendispersion, welche die Messgenauigkeit des Radars 6 herabsetzt. Für die Anwendung im Schmelzofen ist eine Messgenauigkeit von besser als 5 mm aber völlig ausreichend, so dass Modendispersion hier nicht weiter stört.

Wie in Fig. 2 zu sehen ist, ist die lichte Querschnittsabmessung *d* der Rohrinnenhöhlung 19 des Strahlführungsrohrs 18 kleiner als die entsprechenden Außenquerschnittsabmessung *D* des Radars 6. Das Radar 6 steht also seitlich über die Mantelfläche der in Axialrichtung des Strahlführungsrohrs 18 projizierten geraden Verlängerung der Rohrinnenhöhlung 19 über.

Zur thermischen Abschirmung der Radarantenne 7 gegen an dem von dem Radar 6 entfernten Ende des Strahlführungsrohrs 18 herrschende Temperaturen ist in der Rohrinnenhöhlung 19 des Strahlführungsrohrs 18 ein dielektrisches Fenster 20 angeordnet, das für die Radarstrahlung transparent ist.

Aufgrund der Dielektrizitätskonstante des Fensters 20, die größer als 1 ist, kommt es zu einer Teilreflexion des Radarstrahls an der Fensteroberfläche. Um zu verhindern, dass diese Teilreflexion direkt in den Empfänger des Radars 6 einkoppelt, ist die Oberfläche des dielektrischen Fensters 20 zur Längsmittelachse 21 des Strahlführungsrohrs 18 um einen Winkel *β* verkippt, der folgende Ungleichung erfüllt: $β > \frac{α}{2}$

Das radartransparente Fenster 20 ist scheibenförmig ausgestaltet und der Winkel *β* beträgt bei dem Ausführungsbeispiel mindestens 4° (Fig. 2).

Das radartransparente Fenster 20 befindet sich zwischen einem ersten Rohrabschnitt des Strahlführungsrohrs 18 und einem in gerader Verlängerung dazu angeordneten zweiten Rohrabschnitt des Strahlführungsrohrs 18. Der erste Rohrabschnitt erstreckt sich von dem dem Radar 6 zugewandten Axialende des Strahlführungsrohrs 18 bis zu dem Fenster 20 und der zweite Rohrabschnitt erstreckt sich von dem Fenster 20 zu dem anderen Axialende des Strahlführungsrohrs 18. Der zweite Rohrabschnitt ist länger als der erste Rohrabschnitt. Die Rohrabschnitte können einstückig oder auf andere Weise miteinander verbunden sein. Das dielektrische Fenster 20 kann beispielsweise aus Teflon, Nylon, Keramik oder einem anderen geeignetem dielektrischen Material bestehen und muss für die Radarstrahlung 8 zumindest teilweise transparent sein.

Zwischen dem radartransparenten Fenster 20 und dem von der Radarantenne 7 entfernten Axialende des Strahlführungsrohrs 18 befindlichen Abschnitt der Rohrinnenhöhlung 19 hat das Strahlführungsrohr 18 einen Einlass 22 zum Zuführen von Kühlgas.

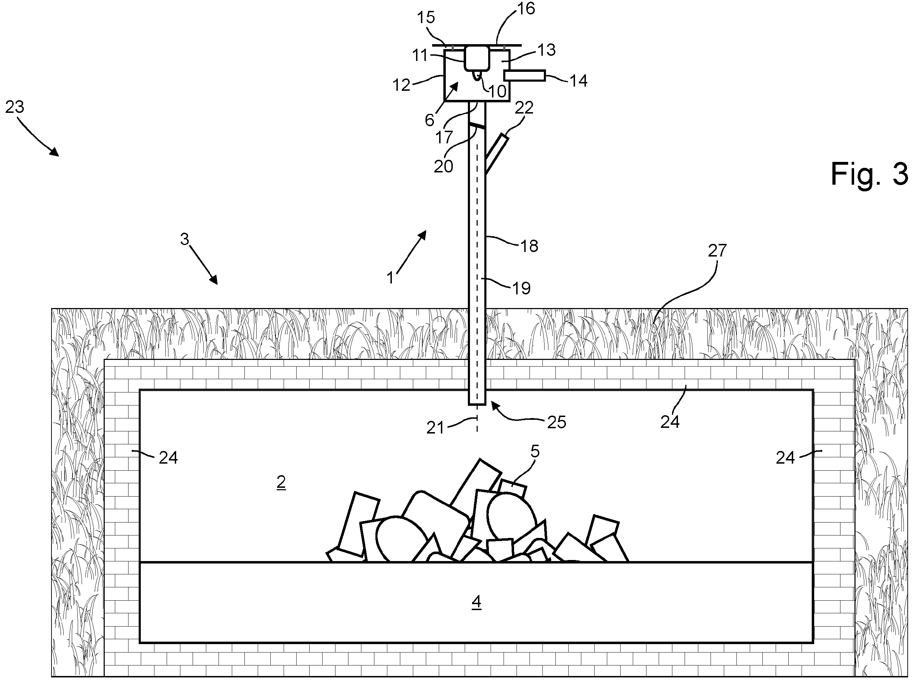

Fig. 3 zeigt einen Längsschnitt durch einen Schmelzofen 23 entlang einer Vertikalebene. Der Schmelzofen 23 weist in seinem Inneren die bereits erwähnte Schmelzkammer 3 auf, die mit Hilfe einer in der Zeichnung nicht näher dargestellten Heizung beheizbar ist. Die Schmelzkammer 3 hat einen Innenraum 2 mit einem Aufnahmebereich für Schmelze 4. Auf dem Boden der Schmelzkammer 3 befindet sich außerdem zu schmelzendes Schüttgut 5, das sich bis über das Niveau bzw. den Oberflächenspiegel der Schmelze 4 erstreckt.

Der Innenraum 2 der Schmelzkammer 3 wird durch Außenwände 24 begrenzt. Diese weisen an ihrer dem Innenraum 2 abgewandten Außenseite eine in der Zeichnung nicht näher dargestellte Wärmeisolationsschicht 27 auf, die aus Mineralwolle oder dergleichen Dämmstoff besteht.

Die Decke der Schmelzkammer 3 hat oberhalb des Aufnahmebereichs für die Schmelze 4 einen Wanddurchbruch 25, den das Strahlführungsrohr 18 der Vorrichtung 1 durchsetzt. An seinem Außenumfang ist das Strahlführungsrohr 18 dicht mit der Decke der Schmelzkammer 3 verbunden.

Das Radar 6 ist oberhalb des Wanddurchbruchs 26 mit Abstand zur Decke angeordnet. Das von dem Radar 6 entfernte untere Ende des Strahlführungsrohrs 18 ragt an der Unterseite der Decke aus dem Wanddurchbruch 26 heraus und steht dort derart in den Innenraum 2 der Schmelzkammer 3 vor, dass es von der Schmelze 4 und dem Schüttgut 5 beabstandet ist.

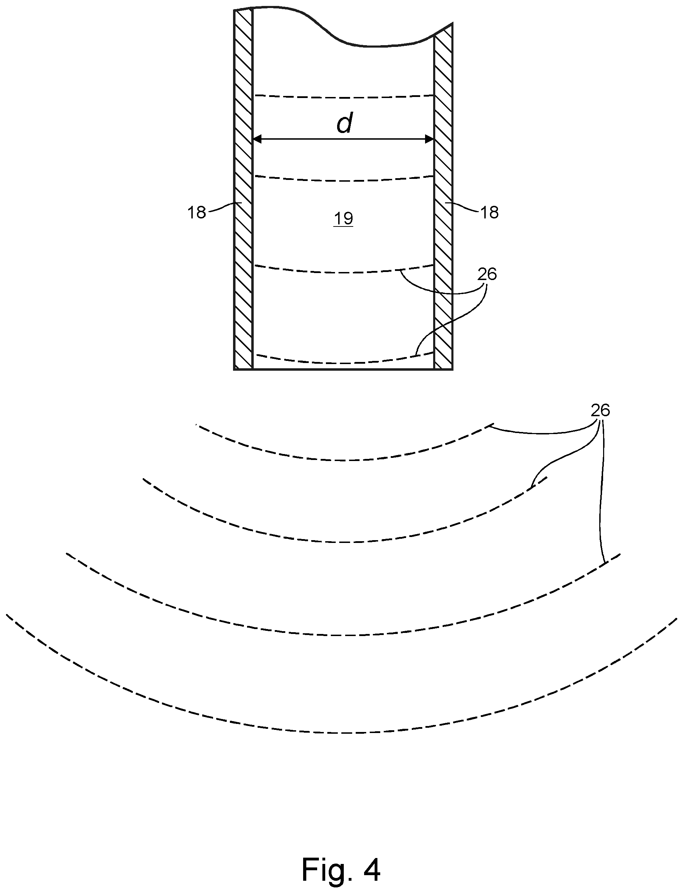

Fig. 4 zeigt die stilisierten Phasenfronten 26 beim Austritt der Radarwelle aus dem Strahlführungsrohr 18. Die Darstellung ist stark vereinfacht, da sich in der Rohrinnenhöhlung 19 nur näherungsweite ebene Wellenfronten ausbreiten. Am Ende des Strahlführungsrohrs 18 divergiert der Radarstrahl. Dadurch nimmt die Radarstrahlintensität mit etwa 1/R² ab. Hier ist R der kürzeste Abstand zwischen der von der Austrittsöffnung des Strahlführungsrohrs 18 aufgespannten Ebene und dem Schüttgut 5 oder der Oberfläche der Schmelze 4.

Nach Reflexion des Radarstrahls am Schüttgut 5 oder an der Schmelze 4 koppelt dieser wieder in das Strahlführungsrohr 18 ein. Daher nimmt die Radarstrahlintensität noch einmal 1/R² ab. Für das Verhältnis zwischen ausgesendeter Millimeterwellen-Leistung *P_{T}* zur Empfangsleistung *P_{R}* gilt daher $\frac{{P}_{R}}{{P}_{T}} < {R}^{- 4}$

Das von dem Radar 6 entfernte Ende des Strahlführungsrohrs 18 sollte daher so nah wie möglich am Schüttgut 4 oder an der Schmelze 5 sein, um R möglichst klein zu halten. R muss jedoch so groß sein, dass das Strahlführungsrohr 18 durch die heiße Schmelzofentemperatur nicht beschädigt wird.

Aus der Laufzeit der Radarwelle wird der Abstand zur Schmelze 4 oder dem Schmelzgut 5 nach einem an sich bekannten Radarverfahren bestimmt. Um die hohe Temperatur innerhalb des Schmelzofens 23 von dem Radar 6 fernzuhalten, ist der Einlass 22 des Strahlführungsrohrs 18 mit einer in der Zeichnung nicht näher dargestellten Gaszuführung verbunden, die kühles Gas, beispielsweise Luft, Helium, Argon oder Stickstoff, in den Einlass 22 bläst.

Dies bewirkt, dass das Strahlführungsrohr 18, das dielektrische Fenster 20, und letztendlich auch das Radargehäuse 12 mit dem darin befindlichen Radar 6 gekühlt wird.

Zum Erfassen einer Änderung des gemessenen Abstands zu dem zu schmelzenden Schüttgut 5 oder der Schmelze 4 hat die Radarelektronik 9 ein in der Zeichnung nicht naher dargestelltes Differenzierglied. Zum Vergleichen der Änderung des Abstandsmesssignals mit einem Referenzwert oder einem Referenzwertbereich ist das Differenzierglied mit einer Vergleichseinrichtung verbunden, die eine Anzeigeeinrichtung ansteuert. Das Differenzierglied und die Vergleichseinrichtung können in Form von Hardware oder mittels einer geeigneten Software realisiert sein, die auf einem Mikrocomputer abläuft.

Am Anfang des Schmelzvorgangs bildet das Schüttgut 5 beispielsweise einen Haufen und das Radar 6 misst einen kleinen Abstand zum Schüttgut 5. Im weiteren Schmelzverlauf bildet sich eine flüssige Schmelze 4. Das Niveau der flüssigen Schmelze 4 steigt im zeitlichen Verlauf stetig an. Das noch nicht aufgeschmolzene Schüttgut 5 sinkt im zeitlichen Verlauf in die Schmelze 4. Dadurch vergrößert sich der vom Radar 6 gemessene Abstand. Wenn das Radar 6 keine zeitliche Änderung des Abstands mehr registriert, ist das Schmelzgut vollständig aufgeschmolzen und das Radar 6 misst den Abstand zum Niveau der Schmelze 4. Aus der bekannten Geometrie der Schmelzkammer 3 wird dann das Volumen der Schmelze 4 bestimmen.

Es ist auch möglich, zu Beginn des Schmelzvorgangs mit Hilfe des Radars 6 den Abstand zum Boden der Schmelzkammer 3 zu messen. Wenn das Schüttgut 5 zu schmelzen beginnt, wird der Boden von der Schmelze 4 bedeckt, so dass das Radar den Abstand zur Schmelze 4 misst. Hierdurch nimmt der gemessene Abstand ab. Wenn das gesamte Schüttgut 5 geschmolzen oder in die Schmelze 4 eingetaucht ist, ändert sich der gemessene Abstand nicht mehr und die Anzeigeeinrichtung für die Beendigung des Schmelzprozesses wird aktiviert.

Bei Bedarf kann zwischen dem Differenzierglied der Radarelektronik 9 und der Anzeigeeinrichtung ein Verzögerungslied angeordnet sein. Wenn der Vergleich zwischen dem Abstandsmesssignal und dem Referenzwert oder dem Referenzwertbereich ergibt, dass sich das Abstandsmesssignal nicht mehr oder nur noch unwesentlich ändert, wird in diesem Fall die Anzeigeeinrichtung erst nach Ablauf einer Zeitverzögerung aktiviert, um sicherzustellen.

## Patentansprüche

1. Vorrichtung (1) zur Durchführung von Abstandsmessungen an einer in dem Innenraum (2) einer Schmelzkammer (3) befindlichen Schmelze (4) und/oder eines in dem Innenraum (2) befindlichen, zu schmelzenden Schüttguts (5), mit einem Radar (6), das mindestens eine Radarantenne (7) zum Senden und Empfangen von Radarstrahlung und eine damit zusammenwirkende Radarelektronik (9) aufweist, die zur Abstandsmessung nach dem Laufzeitprinzip ausgestaltet ist, **dadurch gekennzeichnet, dass** die Vorrichtung (1) ein Strahlführungsrohr (18) mit einer für die Radarstrahlung reflektierenden, eine Rohrinnenhöhlung (19) umgrenzenden Innenwand hat, dass das Strahlführungsrohr (18) an seinen beiden Axialenden für die Radarstrahlung offen und die Radarantenne (7) einem der Axialenden des Strahlführungsrohrs (18) zugewandt ist, und dass das Radar (6) derart ausgestaltet und ausgerichtet ist, dass die von ihm ausgesendete Radarstrahlung durch die Rohrinnenhöhlung (19) des Strahlführungsrohrs (18) hindurch zu dem gegenüberliegenden anderen Axialende des Strahlführungsrohrs (18) gelangt und dort aus dem Strahlführungsrohr (18) austritt.

2. Vorrichtung (1) nach Anspruch 1, **dadurch gekennzeichnet, dass** die Querschnittsabmessungen (d) der Rohrinnenhöhlung (19) des Strahlführungsrohrs (18) kleiner sind als die entsprechenden Außenquerschnittsabmessungen (*D*) des Radars (6).

3. Vorrichtung (1) nach Anspruch 1 oder 2, **dadurch gekennzeichnet, dass** das Radar (6) zum Reduzieren des Öffnungswinkels (α) der von der Radarantenne (7) ausgesendeten Radarkeule eine dielektrische, vorzugsweise elliptische Linse (20) aufweist, und dass die dielektrische Linse (20) zwischen der Radarantenne (7) und dem Strahlführungsrohr (18) angeordnet ist.

4. Vorrichtung (1) nach Anspruch 3, **dadurch gekennzeichnet, dass** die dielektrische Linse (20) derart ausgestaltet ist, dass der auf die virtuelle Abstrahlstelle der Radarantenne (7) bezogene -3dB Öffnungswinkel α der Radarkeule die Ungleichung $α \leq 2 arc tan \frac{d}{2 a}$ erfüllt, wobei *d* die Querschnittsabmessung der Rohrinnenhöhlung (19) des Strahlführungsrohrs (18) und *a* der Abstand ist, den die virtuelle Abstrahlstelle der Radarantenne (7) entlang der Längsmittelachse (21) des Strahlführungsrohrs (18) zu der Rohrinnenhöhlung (19) des Strahlführungsrohrs (18) aufweist.

5. Vorrichtung (1) nach Anspruch 3 oder 4, **dadurch gekennzeichnet, dass** die dielektrische Linse (20) derart ausgestaltet ist, dass der auf die virtuelle Abstrahlstelle der Radarantenne (7) bezogene Öffnungswinkel α der Radarkeule kleiner als oder gleich 6° ist, insbesondere kleiner als oder gleich 5° und bevorzugt kleiner als oder gleich 4° ist.

6. Vorrichtung (1) nach einem der Ansprüche 1 bis 5, **dadurch gekennzeichnet, dass** zur thermischen Abschirmung des Radars (6) gegen an dem von dem Radar (6) entfernten Ende des Strahlführungsrohrs (18) herrschende Temperaturen ein radartransparentes Fenster (20) in der Rohrinnenhöhlung (19) des Strahlführungsrohrs (18) angeordnet ist.

7. Vorrichtung (1) nach Anspruch 6, **dadurch gekennzeichnet, dass** das Strahlführungsrohr (18) zumindest einen ersten Rohrabschnitt und einen in gerader Verlängerung dazu angeordneten zweiten Rohrabschnitt aufweist, und dass das radartransparente Fenster (20) zwischen diesen Rohrabschnitten angeordnet und diese miteinander verbindet.

8. Vorrichtung (1) nach Anspruch 6 oder 7, **dadurch gekennzeichnet, dass** das radartransparente Fenster (20) scheibenförmig ausgestaltet ist, und dass die Normale auf die Oberfläche des radartransparenten Fenster (20) aufgespannte Ebene unter einem Neigungswinkel *β* gegenüber der Längsmittelachse (21) des Strahlführungsrohrs (18) verkippt ist, der größer ist als die Hälfte des -3dB Öffnungswinkels *α* der aus der Linse (20) austretenden Radarkeule.

9. Vorrichtung (1) nach einem der Ansprüche 1 bis 8, **dadurch gekennzeichnet, dass** das Radar (6) zum Aussenden einer Radarstrahlung mit einer Wellenlänge λ ausgestaltet ist, und dass die lichte Querschnittsabmessung der Rohrinnenhöhlung (19) des Strahlführungsrohrs (18) zwischen dem Zweifachen und dem Fünfzigfachen der Wellenlänge λ, gegebenenfalls zwischen dem Zweifachen und dem Dreißigfachen der Wellenlänge λ, optional zwischen dem Zweifachen und dem Zwanzigfachen der Wellenlänge λ und bevorzugt zwischen dem Zehnfachen und dem Fünfzigfachen der Wellenlänge λ beträgt.

10. Vorrichtung (1) nach einem der Ansprüche 1 bis 9, **dadurch gekennzeichnet, dass** die Radarelektronik ein Differenzierglied zum Erfassen einer Änderung eines Abstandsmesssignals aufweist, und dass das Differenzierglied zum Vergleichen der Änderung des Abstandsmesssignals mit einem Referenzwert oder einem Referenzwertbereich mit einer Vergleichseinrichtung verbunden ist.

11. Vorrichtung (1) nach einem der Ansprüche 1 bis 10, **dadurch gekennzeichnet, dass** die Vorrichtung (1) ein mit dem der Radarantenne (7) zugewandten Axialende des Strahlführungsrohrs (18) verbundenes Radargehäuse (12) hat, das einen Aufnahmeraum (13) umgrenzt, in dem das Radar (6) angeordnet ist, dass das Radargehäuse (12) an dem der Radarantenne (7) zugewandten Axialende des Strahlführungsrohrs (18) eine Durchtrittsöffnung für die Radarstrahlung aufweist, und dass das Radargehäuse mindestens eine Einlassöffnung (14) zum Zuführen von Kühlgas in den Aufnahmeraum (13) und wenigstens einen Auslass (15) für das Kühlgas aufweist.

12. Vorrichtung (1) nach einem der Ansprüche 6 bis 11, **dadurch gekennzeichnet, dass** das Strahlführungsrohr in (18) einem zwischen dem radartransparenten Fenster (20) und dem von der Radarantenne (7) entfernten Axialende des Strahlführungsrohrs (18) befindlichen Abschnitt der Rohrinnenhöhlung (19) einen Einlass (22) zum Zuführen von Kühlgas aufweist.

13. Schmelzofen (23), mit einer durch Außenwände begrenzten Schmelzkammer (3), die einen Innenraum (2) mit einem Aufnahmebereich für eine Schmelze (4) begrenzt, wobei mindestens eine Außenwand (24) einen Wanddurchbruch (25) aufweist, der höher angeordnet ist als der Aufnahmebereich für die Schmelze (4), und mit einer Vorrichtung (1) nach einem der Ansprüche 1 bis 12, wobei das Strahlführungsrohr (18) der Vorrichtung (1) den Wanddurchbruch (25) durchsetzt und an seinem Außenumfang dicht mit der Außenwand (24) verbunden ist, und wobei das Radar (6) an dem von dem Innenraum (2) der Schmelzkammer (3) entfernten Axialende des Strahlführungsrohrs (18) vorzugsweise außerhalb des Wandungsdurchbruchs (25) angeordnet ist.

14. Schmelzofen (23) nach Anspruch 13, **dadurch gekennzeichnet, dass** das Strahlführungsrohr (18) an der dem Innenraum (2) zugewandten Innenfläche der den Wanddurchbruch (25) aufweisenden Außenwand einen in den Innenraum (2) vorstehenden Rohrabschnitt hat, und dass dieser Rohrabschnitt - ausgehend von dem Wanddurchbruch (25) zu dem davon entfernten Ende des Rohrabschnitts - vorzugsweise eine nach unten weisende Komponente hat.

15. Schmelzofen (23) nach Anspruch 13 oder 14, **dadurch gekennzeichnet, dass** die Schmelzkammer (3) einen Boden, Seitenwände und eine Decke hat, und dass der von dem Strahlführungsrohr (18) durchsetzte Wanddurchbruch (25) in der Decke der Schmelzkammer (3) angeordnet ist.
